Europäisches Patentamt

European Patent Office

Office européen des brevets

(11) Publication number: **0 239 073**
A2

## EUROPEAN PATENT APPLICATION

(21) Application number: 87104315.4

(22) Date of filing: 24.03.87

(51) Int. Cl.⁴: **H 03 K 3/288**, H 03 K 3/289

(30) Priority: 25.03.86 JP 66268/86

(43) Date of publication of application: 30.09.87
Bulletin 87/40

(84) Designated Contracting States: DE FR GB

(71) Applicant: Kabushiki Kaisha Toshiba, 72, Horikawa-cho
Saiwai-ku, Kawasaki-shi Kanagawa-ken 210 (JP)

(72) Inventor: Oida, Yoshio c/o Patent Division, Kabushiki
Kaisha Toshiba 1-1 Shibaura 1-chome, Minato-ku Tokyo
(JP)

(74) Representative: Henkel, Feiler, Hänzel & Partner,
Möhlstrasse 37, D-8000 München 80 (DE)

(54) Frequency divider.

(57) According to this invention, disclosed is a frequency divider using an ECL type FF circuit, wherein the frequency characteristics of the frequency divider in a high-frequency range, in particular, the cut-off frequency $f_T$ of bipolar transistors used in the FF circuit, are improved, and a maximum operation-frequency is improved. In this invention, an adverse influence of stray capacitances present between the emitters and collectors of bipolar transistors ($Q_1$ to $Q_6$) against the frequency characteristics in the high-frequency range can be eliminated by peaking circuits (10, 11).

- 1 -

Frequency divider

The present invention relates to a frequency divider and, more particularly, to an integrated frequency divider which employs an emitter coupled logic type flip-flop circuit and can improve a maximum operation frequency of a transistor.

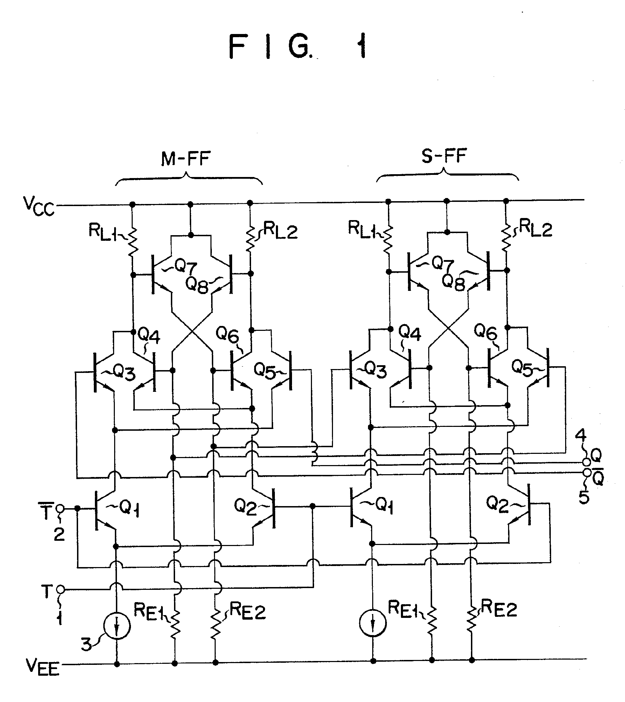

Fig. 1 shows a conventional frequency divider employing an emitter-coupled logic (to be referred to as ECL hereinafter) type flip-flop circuit (to be referred to as an FF circuit hereinafter). As shown in Fig. 1, the ECL FF circuit is constituted by master and slave FF circuits. In Fig. 1, the master FF circuit comprises transistors $Q_1$ to $Q_8$, resistors $R_{E1}$, $R_{E2}$, $R_{L1}$, and $R_{L2}$, clock input terminal 12, constant power source 3, and frequency dividing output terminals 1 and 2. The slave FF circuit has the same arrangement as the master FF circuit.

The conventional ECL FF circuit has the following problems. More specifically, in this frequency divider, stray capacitances (not shown) are respectively present between transistors $Q_3$ and $Q_4$, between transistors $Q_5$ and $Q_6$, between the node of the collectors of transistors $Q_3$ and $Q_4$ and a ground potential, and between the node of the collectors of transistors $Q_5$ and $Q_6$ and the ground potential. Due to the stray capacitances, the transistors cannot satisfactorily effect their operation characteristics (mainly, cut-off frequency fT).

Therefore, the maximum frequency characteristics of the transistors are impaired. For this reason, the response property of the frequency divider with respect to a high-frequency clock input, i.e., the follow-up property, is degraded.

In order to improve the maximum frequency characteristics of transistors, cut-off frequency fT can be improved by improving the manufacturing process. However, the frequency divider itself must also be improved.

United States Patent No. 3,996,478, Dec. 7, 1976, to Wolfdietrich Georg Kasperkovitz, "Frequency Divider for High Frequencies" discloses that a delay caused by the base resistors of transistors (T5, T6) of a differential amplifier for driving the collector of a bistable circuit must be partially compensated in order to obtain high frequency characteristics.

It is an object of the present invention to provide a frequency divider employing an ECL FF circuit, which simply improves a circuit arrangement using a conventional manufacturing process and can improve operation characteristics, i.e., increase a maximum frequency capable of frequency-dividing operation.

A frequency divider of the present invention comprises a first differential transistor-pair circuit which consists of a pair of emitter-coupled bipolar transistors and performs an inverting switching operation in response to an inverted clock input; a second differential transistor-pair circuit which consists of a pair of bipolar transistors whose emitters are connected to the collector of one transistor provided in the first differential transistor-pair circuit, is switched between enabled and disabled states in response to the differential switching operation of the first differential transistor-pair circuit, and reads data from a data input terminal; a third differential transistor-pair circuit which consists of a pair of bipolar transistors whose emitters are connected to the collector of the other transistor provided in the first differential transistor-pair circuit, and is switched between enabled and disabled states in a complementary manner with the second differential transistor-pair circuit in response to the differential switching operation of the first differential transistor-pair circuit; a data holding transistor circuit which consists of a pair of bipolar transistors whose emitters are cross-coupled to the bases of the transistors provided in the third differential transistor-pair circuit, and holds data together with the third differential transistor pair circuit; and first and second peaking circuits which are parallel-arranged between the second and third differential transistor-pair circuits and between the data holding transistor circuit and a power source terminal.

In the frequency divider of the present invention, the first differential transistor-pair circuit performs the differential switching operation in response to the inverted clock input so as to enable the second differential transistor-pair circuit and to disable the third differential transistor-pair circuit. Thus, data input to the second differential transistor-pair circuit is read.

When the inverted clock input is inverted, the second differential transistor-pair circuit is disabled, and the third differential transistor-pair circuit is enabled. In this state, the data read by the third differential transistor-pair circuit and the data holding transistor circuit is held. As a result, a data output from the third differential transistor-pair circuit is frequency-divided.

In the frequency divider of the present invention, a stray capacitance is inevitably present between a ground potential and the node of the collectors of the bipolar transistors constituting the second and third differential transistor-pair circuits. Therefore, in the frequency divider of the present invention, the first and second peaking circuits are caused to generate an inductive impedance in a predetermined high-frequency range, thereby eliminating the adverse influence of the stray capacitance present on the collector side of the transistors of the differential transistor-pair circuits.

Therefore, cut-off frequency fT of bipolar transistors used in the frequency divider can be increased. In addition, the maximum operation frequency of the transistors can be increased up to a high-frequency range.

The frequency divider of the present invention can perform a frequency-dividing operation with good response and follow-up properties with respect to a high-frequency input.

In addition, the circuit arrangement itself is improved without improving the manufacturing process in order to improve the maximum operation frequency characteristics of the frequency divider.

This invention can be more fully understood from the following detailed description when taken in conjunction with the accompanying drawings, in which:

Fig. 1 is a circuit diagram showing a conventional frequency divider;

Fig. 2 is a circuit diagram showing a frequency divider according to an embodiment of the present invention;

Fig. 3 is a timing chart for explaining the operation of the frequency divider shown in Fig. 2;

Fig. 4 is a circuit diagram showing an ECL type frequency divider as an application of the frequency divider shown in Fig. 2; and

Fig. 5 is a timing chart for explaining the operation of the ECL type frequency divider shown in Fig. 4.

A frequency divider according to the present invention will now be described with reference to the accompanying drawings. NPN bipolar transistors (to be referred to simply as transistors hereinafter) $Q_1$, $Q_2$, $Q_3$, $Q_4$, $Q_5$, and $Q_6$ respectively constitute differential transistor-pair circuits. The bases of transistors $Q_1$ and $Q_2$ are connected to inverted clock $\overline{T}$ input terminal 2 and clock T input terminal 1. The emitters of transistors $Q_1$ and $Q_2$ are connected to a $V_{EE}$ power source terminal (normally a ground terminal) at the low potential side through constant current source 3. The emitters of transistors $Q_3$ and $Q_5$ are connected to the collector of transistor $Q_1$. The base of transistor $Q_3$ is connected to inverted data $\overline{D}$ input terminal 7. The base of transistor $Q_5$ is connected to data input D terminal 6. The emitters of transistors $Q_4$ and $Q_6$ are connected to the collector of transistor $Q_2$. The bases of transistors $Q_4$ and $Q_6$ are connected to inverted data $\overline{Q}$ output terminal 9 and data output Q terminal 8, respectively, and are also connected to the $V_{EE}$ power source terminal through resistors $R_{E1}$ and $R_{E2}$, respectively. The collectors of transistors $Q_3$ and $Q_4$ are connected to each other, and form collector common node N1. The collectors of transistors $Q_5$ and $Q_6$ are connected, forming collector common node N2. The base of transistor $Q_7$ is connected to collector common node N1, and the emitter of transistor $Q_7$ is connected to the base of transistor $Q_6$. The base of transistor $Q_8$ is connected to collector common node N2, and the emitter of transistor $Q_8$ is connected to the base of transistor $Q_4$. The collectors of transistors $Q_7$ and $Q_8$ are connected to power source terminal $V_{CC}$ at the high potential.

Peaking circuit 10 is connected to power source terminal $V_{CC}$, and also to collector common node N1 by load resistor $R_{L1}$. Peaking circuit 11 is coupled to power source terminal $V_{CC}$, and also to collector common node N2 by load resistor $R_{L2}$. In peaking circuit 10, collector load resistor $R_{C1}$ for transistor $Q_9$, the collector and emitter of transistor $Q_9$ are series-connected between power source terminal $V_{CC}$ and load resistor $R_{L1}$. The base of transistor $Q_9$ is connected to power source terminal $V_{CC}$ by base current limiting resistor $R_{B1}$. Similarly, peaking circuit 11 comprises transistor $Q_{10}$, collector load resistor $R_{C2}$, and base current-limiting resistor $R_{B2}$. The connection between this and other circuit components is the same as that of peaking circuit 10, and a description thereof is omitted.

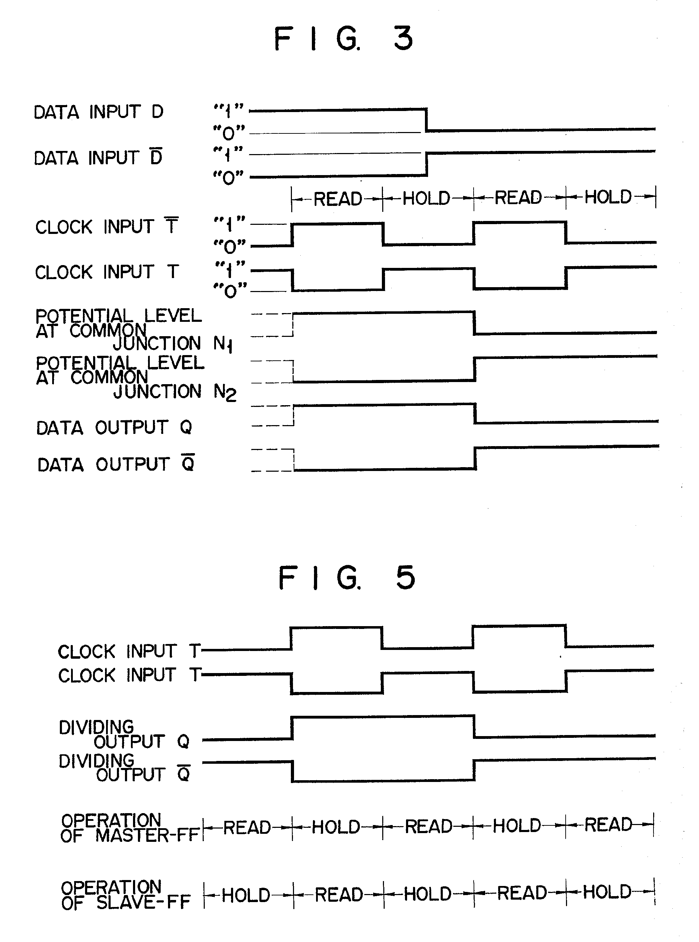

The operation of the frequency divider of the present invention will be described hereinafter. The data-read and -hold operations which the frequency divider performs when a "0"-level inverted data input $\overline{D}$ signal is input from inverted data input terminal 7 to transistor $Q_3$, and when a "1"-level data input D signal is input from inverted data input terminal 6 to transistor $Q_6$, will be described with reference to Fig. 3. Inverted clock input $\overline{T}$ is input from inverted clock input terminal 2 to the base of transistor $Q_1$, and clock input T is input from clock input terminal 1 to the base of transistor Q2.

When inverted clock input $\overline{T}$ is at "1" level and clock input T is at "0" level, transistor $Q_1$ is turned on, and transistor $Q_2$ is turned off.

When transistor $Q_1$ is turned on, transistors $Q_3$ and $Q_5$ are enabled. Meanwhile, when transistor $Q_2$ is turned off, transistors $Q_4$ and $Q_6$ are disabled.

In this case, since inverted data input D is at "0" level and data input D is at "1" level, as described above, transistor $Q_3$. is turned off, and transistor $Q_5$ is turned on.

Therefore, "1"-level data is read at collector common node N1, and "0"-level data is read at collector common node N2.

When clock inputs $\overline{T}$ and T are respectively inverted to "0" level and "1" level, transistor $Q_1$ is turned off, and transistor $Q_2$ is turned on.

Therefore, transistors $Q_3$ and $Q_5$ are disabled, and transistors $Q_4$ and $Q_5$ are enabled. Data read at collector common nodes N1 and N2 are held by transistors $Q_7$, $Q_8$, $Q_4$, and $Q_6$, respectively.

Transistor $Q_7$ is turned on and transistor $Q_8$ is turned off in accordance with read data "1" and "0" read at collector common nodes N1 and N2.

As a result, a "1"-level output appears at data output terminal 8, and a "0"-level output appears at data output terminal 9.

In an FF circuit constituting the frequency divider, peaking circuit 10 consisting of load transistor $Q_9$, collector load resistor $R_{C1}$, and base current-limiting resistor $R_{B1}$ has an impedance representing an inductive property in the emitter direction of transistor $Q_9$ in a predetermined high-frequency range. More specifically, peaking circuit 10 has peaking characteristics.

This also applies to peaking circuit 11.

Since peaking circuits 10 and 11 have the peaking characteristics, the adverse influence of stray capacitances present between collector common nodes N1 and N2, on the one hand, and the ground terminal, on the other, is eliminated.

Therefore, the frequency characteristics of bipolar transistors used in the FF circuit, in particular, cutoff frequency fT, is improved, and a free-running oscillation frequency as a maximum operation frequency, can be greatly improved.

Note that collector load resistors $R_{C1}$ and $R_{C2}$ can be omitted from peaking circuits 10 and 11. In addition, npn transistors used in the FF circuit can be replaced with pnp transistors, and the relationship between power source potentials can be inverted.

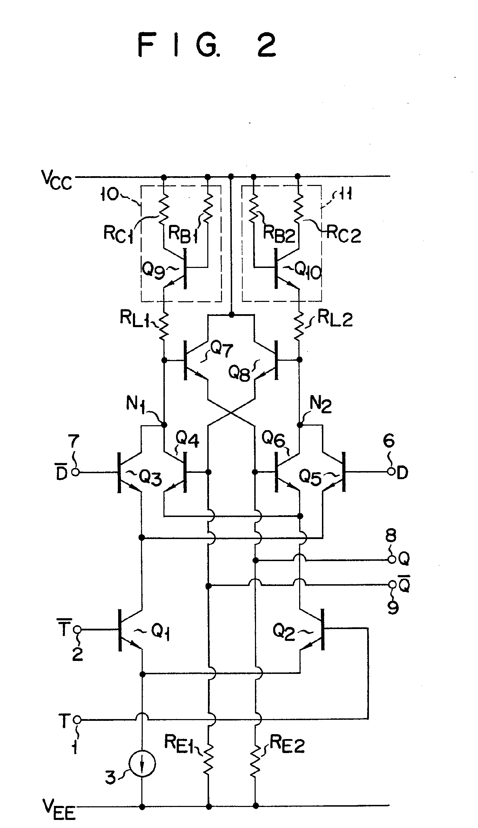

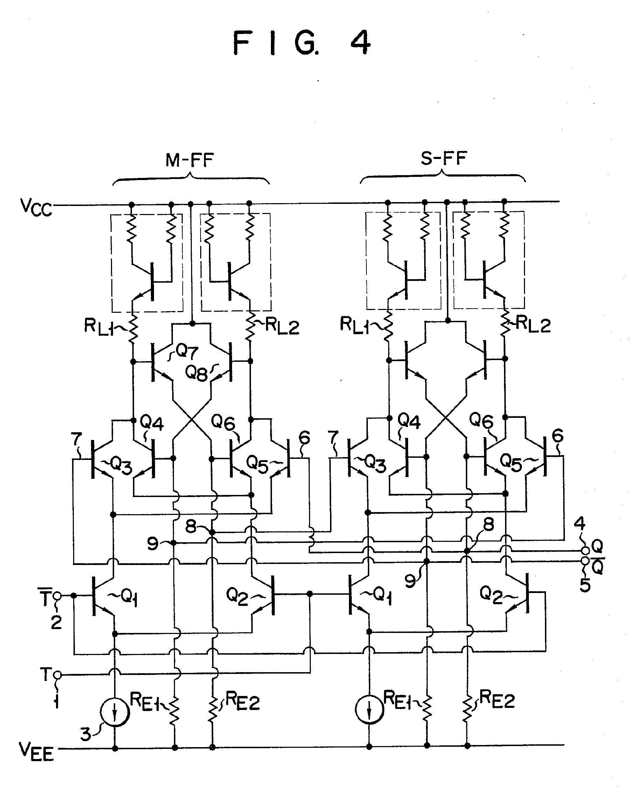

Fig. 4 is a circuit diagram showing an ECL type frequency divider using the FF circuit shown in Fig. 2.
Master FF circuit M-FF and slave FF circuit S-FF have
the same configuration as that of the FF circuit shown
in Fig. 2.   In this frequency divider, data output terminals 8 and 9 of master FF circuit M-FF are respectively connected in correspondence with data input
terminals 7 and 6 of slave FF circuit S-FF.   Clock
inputs T and R are input in correspondence with the
bases of transistors $Q_1$ and $Q_2$ constituting the dif-
ferential transistor pair circuit of slave FF circuit
S-FF.   Data output terminals of slave FF circuit S-FF
are feedback-connected in correspondence with data input
terminals 6 and 7 of master FF circuit M-FF, so as to
serve as frequency-dividing output terminals 4 and 5.

The frequency-dividing operation of the frequency
divider shown in Fig. 4 is known to those skilled in
the art, and is performed as shown in the timing chart
shown in Fig. 5, so that clock inputs $\overline{T}$ and T are frequency divided to obtain frequency-divided outputs Q
and $\overline{Q}$.   Since the frequency divider shown in Fig. 4
also has peaking circuits 10 and 11, the maximum
operation-frequencies of master FF circuit M-FF and
slave FF circuit S-FF are high, and the maximum
operation-frequency of the frequency divider is also
high.   Thus, a stable frequency-dividing operation can
be performed with respect to a clock input at 1 GHz or
higher.

- 1 -

Claims:

1. A frequency divider consisting of an emitter coupled logic type flip-flop circuit, comprising:

a first differential transistor-pair circuit consisting of first and second transistors ($Q_1$, $Q_2$), the emitters of which are coupled to each other and connected to first power source terminal and the bases of which receive complementary clock inputs so as to perform a differential switching operation;

a second differential transistor-pair circuit consisting of third and fourth transistors ($Q_3$, $Q_5$), the emitters of which are connected to the collector of said first transistor ($Q_1$) of said first differential transistor-pair circuit and the bases of which receive complementary data inputs;

a third differential transistor-pair circuit consisting of fifth and sixth transistors ($Q_4$, $Q_6$), the emitters of which are connected to the collector of said second transistor ($Q_2$) of said first differential transistor-pair circuit, the collector of said fifth transistor ($Q_4$) being connected to the collector of said third transistor ($Q_3$) of said second differential transistor-pair circuit, and the collector of said sixth transistor ($Q_6$) being connected to the collector of said fourth transistor ($Q_5$) of said second differential transistor-pair circuit;

a seventh transistor ($Q_7$), the base of which is connected to the collector of said fifth transistor ($Q_4$) of said third differential transistor-pair circuit, and the emitter of which is connected to the base of said sixth transistor ($Q_6$);

an eighth transistor ($Q_8$), the base of which is connected to the collector of said sixth transistor ($Q_6$) of said third differential transistor-pair circuit, and the emitter of which is connected to the base of said fifth transistor ($Q_5$);

a first peaking circuit (10) arranged between the base of said seventh transistor ($Q_7$) and a power source terminal ($V_{CC}$); and

a second peaking circuit (11) arranged between the base of said eighth transistor ($Q_8$) and said power source terminal ($V_{CC}$).

2. A frequency divider according to claim 1, characterized in that said first peaking circuit (10) includes a ninth transistor ($Q_9$), the emitter of which is connected to the base of said seventh transistor ($Q_7$), the collector of which is connected to said power source terminal ($V_{CC}$), and the base of which is connected to said power source terminal ($V_{CC}$) through a base current-limiting resistor ($R_{B1}$).

3. A frequency divider according to claim 1, characterized in that said second peaking circuit (11) includes a tenth transistor ($Q_{10}$), the emitter of which is connected to the base of said eighth transistor ($Q_8$), the collector of which is connected to said power source terminal ($V_{CC}$), and the base of which is connected to said power source terminal ($V_{CC}$) through a base current-limiting resistor ($R_{B2}$).

4. A frequency divider according to claim 2, characterized in that said first peaking circuit (10) has a collector load resistor ($R_{C1}$) between the collector of said ninth transistor ($Q_9$) and said power source terminal ($V_{CC}$).

5. A frequency divider according to claim 3, characterized in that said second peaking circuit (11) has a collector load resistor ($R_{C2}$) between the collector of said tenth transistor ($Q_{10}$) and said power source terminal ($V_{CC}$).

F I G. 1

# F I G. 2

# F I G. 3

| DATA INPUT D | "1" "0" |
| DATA INPUT $\overline{D}$ | "1" "0" |

|←READ→|←HOLD→|←READ→|←HOLD→|

| CLOCK INPUT $\overline{T}$ | "1" "0" |
| CLOCK INPUT T | "1" "0" |
| POTENTIAL LEVEL AT COMMON JUNCTION $N_1$ | |
| POTENTIAL LEVEL AT COMMON JUNCTION $N_2$ | |
| DATA OUTPUT Q | |
| DATA OUTPUT $\overline{Q}$ | |

# F I G. 5

CLOCK INPUT T
CLOCK INPUT T

DIVIDING OUTPUT Q
DIVIDING OUTPUT $\overline{Q}$

OPERATION OF MASTER-FF |←READ→|←HOLD→|←READ→|←HOLD→|←READ→|

OPERATION OF SLAVE-FF |←HOLD→|←READ→|←HOLD→|←READ→|←HOLD→|

# F I G. 4